# EUROPEAN PATENT SPECIFICATION

(11) **EP 0 449 309 B1**
(45) Date of publication and mention of the grant of the patent: **28.09.2005**
(21) Application number: 91105070.6
(22) Date of filing: 28.03.1991
(51) Int. Cl.: H01L 21/3205, H01L 21/70, H01L 49/02, H01B 1/22, H05K 3/10, H05K 1/09, H01B 1/02, B22F 9/12

(54) **Method of making metalic thin film**
Verfahren zur Herstellung eines dünnen metallischen Films
Méthode de fabrication d'une pellicule métallique mince

(30) Priority: 29.03.1990 JP 8163590
(43) Date of publication of application: 02.10.1991
(73) Proprietor: Ulvac Materials Inc., Chiba-ken 289-1226 (JP)
(72) Inventor: Oda, Masaaki, Sanbu-cho, Sanbu-gun, Chiba-ken (JP)
(74) Representative: Melzer, Wolfgang

(56) References cited:
- EP-A- 0 263 676
- DE-A- 3 134 918
- DE-B- 1 227 822
- US-A- 4 617 237
- PATENT ABSTRACTS OF JAPAN vol. 7, no. 173 (M-232) 30 July 1983 & JP-A-58 076 287 (MITSUBISHI DENKI K.K.) 9 May 1983
- PATENT ABSTRACTS OF JAPAN vol. 12, no. 247 (M-717) 13 July 1988 & JP-A-63 034 157 (MITSUBISHI ELECTRIC CORP.) 13 February 1988
- PATENT ABSTRACTS OF JAPAN vol. 10, no. 40 (M-454) 18 February 1986 & JP-A-60 192 658 (MITSUBISHI DENKI K.K.) 1 October 1985

## Description

### TECHNICAL FIELD

This invention relates to a method of making a metallic thin film and, in particular, to a method of making a metallic thin film with a paste of superfine (ultrafine) metallic particles.

### BACKGROUND ART

Metallic thin films are conventionally used for making conductor circuits such as wiring, electrodes or the like of print circuit boards, thermal heads, condensers or the like. As the methods of making such metallic thin films, the following three are known.

A first method comprises the steps of: preparing an ordinary metallic paste by mixing particles of a metal or of an alloy thereof, whose particle size is 1 micron or more, with an organic solvent, a binder and an additive; and coating the paste on a substrate and drying and sintering them, thereby making a metallic thin film. In this method, the thickness of the metallic thin film is 5 microns or more.

A second method comprises the steps of coating a substrate with a metal-organic substance of liquid state in which a precious metal and an organic material are chemically combined; and drying and sintering them, thereby making a metallic thin film on the substrate. According to this method, it becomes possible to make a metallic thin film of 1 micron thick or less.

A third method comprises the step of making a metallic thin film by using a vacuum process such as a vacuum deposition method, a sputtering method or the like.

In making circuit patterns of conductive body in the above-described methods, screen printing method is employed in the first method, screen printing or photoetching method is employed in the second method, and photoetching method is employed in the third method, respectively.

In the above-described first method, while the content of metal particles in the metal paste is 50% or more, their particle sizes are 1 micron or more (one "micron" corresponding to 10 nanometers). Therefore, the metallic thin film has a film thickness of as much as 5 to 10 microns. This method thus has problems in that it cannot cope with promoting a decrease in the thickness of the film and that the amount of consumption of gold, platinum, paradium or the like which is high in material cost increases, resulting in a product which is high in an overall cost.

In the above-described second method, since the precious metal is present in the organometallic substance in the atomic condition, it is easy to promote a decrease in the thickness of the metallic film. However, since the content of the metallic composition is 20% at most, it is necessary to repeat 2 to 3 times the steps of coating, drying and sintering in order to obtain the thickness of 0.2 to 0.3 micron or more, resulting in a problem in that much time is required for making the film. Further, in this method, the organometallic substance to be used often contains harmful substances such as cyanogen and, therefore, there is a problem in safety and hygiene in the step of sintering.

Furthermore, in the third method, since a vacuum batch treatment is required, the productivity is low. In addition, since an easy patterning method such as screen printing or the like cannot be employed, there is a problem in that the productivity is low also in this respect. Moreover, document US-A-4877647 shows a method of forming a metallic thin film from a metallic solution prepared by warming a frozen matrix of vaporized metal atoms and organic solvent.

Considering the problems associated with the above-described three methods of making metallic thin films, this invention has an object of providing a method of making a thinner metallic thin film in an easy way.

### DISCLOSURE OF THE INVENTION

The method of making a metallic thin film of this invention is characterized in that a metallic thin film which has a range of film thicknesses between 0.01 micron and 1 micron is made according to the method of claim 1, with a metallic paste and that the metallic paste is prepared by uniformly and highly dispersing ultrafine metallic particles of 0.001 micron to 0.1 micron in diameter in an organic solvent.

As ultrafine metallic particles to be used in this invention method, at least one of the group comprising silver, gold, nickel, indium, tin, zinc, titanium, copper, chromium, tantalum, tungsten, palladium, platinum, iron, cobalt, silicon, rhodium, iridium, ruthenium and osmium or an alloy of the metals may be used.

Further, as an organic solvent to be used in this invention method, a solvent containing one or more of alcohols having 5 carbon atoms or more such as terpineol, citronellol, geraniol, nerol and phenethyl alcohol, or a solvent containing one or more of organic esters such as ethyl acetate, ethyl oleate, butyl acetate and glyceride may be used. A suitable one may be selected out of them depending on the purpose of the metal or metallic film to be used. A suitable organic substance may be added to the organic solvent depending on the necessity.

In order to enhance the adhesion between the metallic thin film and the substrate and to enhance the bonding force among the ultrafine metallic particles, the following bonding agents may be added to the metallic paste. One bonding agent may be B, Si, Pb, an oxide of each of them, or the like, which agent softens in the process of heat treatment and penetrates into the particle layers on the substrate, thereby enhancing the adhesion between the two and enhancing the bonding force among the particles. Another bonding agent may be Cu, Zn, Bi, an oxide of each of them, or the like, which bonding agent chemically bonds with the substance of the substrate in the process of heat treatment, thereby enhancing the combination between the two. It is preferable to introduce the bonding agents in the form of highly dispersed ultrafine particles.

Further, a high molecular substance such as ethyl cellulose may be added to the metallic paste to adjust the viscosity, thereby obtaining optimum screen printing characteristics.

Still further, a surface active agent such as lauryl betaine, cocoyl aminopropyldimethyl aminoacetic acid betaine, or the like may be added to the metallic paste to enhance the dispersion stability of the ultrafine metallic particles in the metallic paste, thereby eliminating the change with the passage of time due to coagulation of the particles.

In the method of making a metallic thin film of this invention, the metallic film can be made, basically in the same way as in the above-described conventional first method, by coating a substrate with the above-described metallic paste and then drying and sintering them. A thickness of the produced metallic film of 1 micron or less was able to be attained. Further, when this metallic film is used in a conductive circuit, it is also possible to attain a film thickness required for the conductive circuit, i.e., 0.3 micron or more, by going through a single step of coating, drying and sintering.

According to this invention, it is possible to make considerably thin and fine metallic thin film in a simple method. As a result, the amount of precious metals to be used can be reduced to a smaller amount, and the cost of manufacturing the metallic thin film is considerably reduced. In addition, when electronic parts are manufactured by using this metallic thin film, their sizes can further be made smaller.

### BRIEF EXPLANATION OF THE DRAWING

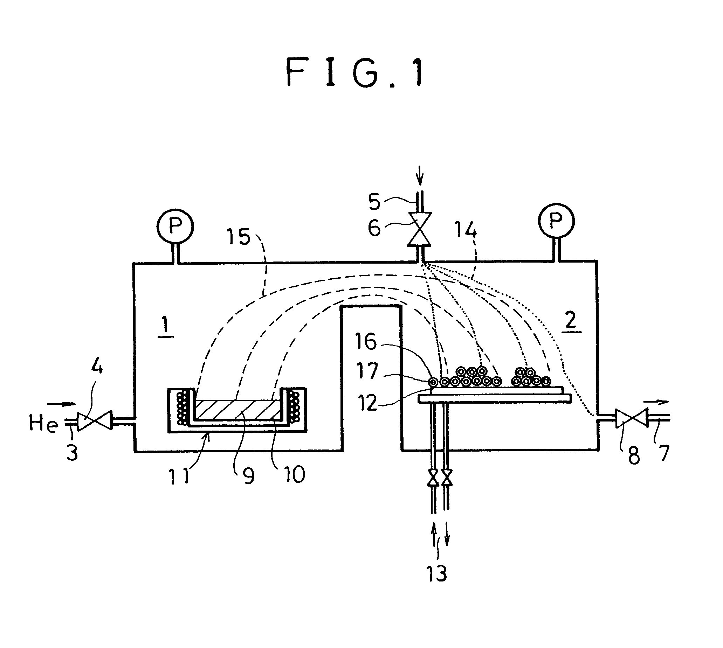

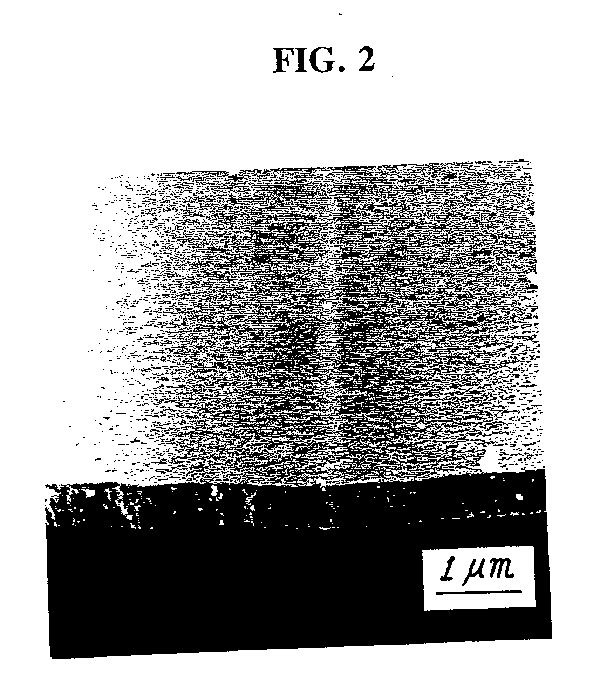

Fig. 1 is a schematic view of an apparatus for manufacturing a metallic paste to be used in making a metallic paste according to this invention method, and Fig. 2 is a photograph by a scanning electron microscope of the conductive film made according to the first embodiment.

### DETAILED DESCRIPTION OF THE INVENTION

A description is made hereinbelow, with reference to the accompanying drawing, about a method of making a metallic thin film in accordance with a preferred embodiment of this invention.

### First Embodiment

Fig. 1 is a schematic view of an example of an apparatus for manufacturing a metallic paste which is used in the method of making a metallic thin film of this invention.

The apparatus for manufacturing the metallic paste is provided with an evaporating chamber 1 and a collection chamber 2, both being in communication with each other. A helium gas passage 3 is connected to the evaporating chamber 1 for introducing helium gas thereinto. A valve 4 for opening and closing this passage 3 is provided in the passage 3. A passage 5 for introducing an organic solvent vapor into the collection chamber 2 is connected to the collection chamber 2 in the neighborhood of that connecting portion of the collection chamber 2 at which the vacuum chamber 1 is connected to the collection chamber 2. In this passage 5 for introducing the organic solvent vapor, there is provided a valve 6 for opening and closing the passage 5. To the collection chamber 2, there is further connected an exhausting passage 7 which is connected to a vacuum pump (not shown) for evacuating the collection chamber 2. This passage 7 is also provided with a valve 8 for opening and closing the passage 7.

Inside the evaporating chamber 1 there is disposed a crucible 10 which contains therein a metal 9 to be used. This crucible 10 is provided with a high-frequency induction heating apparatus 11 for heating the metal 9 inside the crucible 10. On the other hand, the collection chamber 2 is provided therein with a cooling plate 12. This cooling plate 12 is constantly cooled by a coolant which is caused to be circulated by means of a coolant circulating passage 13.

An explanation is made hereinbelow about the manufacturing of the metallic paste by using the apparatus for manufacturing thereof as described above. By the way, in this embodiment, gold was used as the metal and α-terpineol vapor was used as the organic solvent vapor.

First, the valves 4 and 6 were closed and the valve 8 was opened and the vacuum pump was operated to evacuate the evaporating chamber 1 and the collection chamber 2 down to a pressure of 10⁻⁶ Torr. Then, while helium gas was being introduced into the evaporating chamber 1 with the valve 4 open, evacuation through the valve 8 was continued, thereby maintaining the inside thereof at a helium gas pressure of 1 Torr. After this operation, the valve 6 was opened and, while the α-terpineol vapor 14 was being introduced into the collection chamber 2, the gold 9 inside the crucible 10 was heated by the high-frequency induction heating apparatus 11, thereby generating gold vapor 15. The gold vapor 15 was transferred from the evaporating chamber 1 to the collection chamber 2 with the flow of the evacuating gas. In this flow of evacuating gas the gold vapor 15 was condensed to superfine (ultrafine) gold particles. These superfine gold particles were mixed with α-terpineol vapor 14 in the collection chamber 2 and were deposited on the cooling plate 12 which was kept at a low temperature by the coolant 13, as stabilized superfine gold particles 17 covered with thin films 16 of α-terpineol. When these deposits were recovered and observed by a transmission electron microscope, it was found that the superfine gold particles were neither agglomerated nor chained together but were well independently dispersed in the α-terpeneol. This phenomena seem to be due to the fact that, because the superfine gold particles are well mixed with the α-terpineol vapor, they are wrapped by the α-terpeneol in a film form before bonding of the gold particles takes place. The gold particles were spherical in shape and uniform, with their particle sizes being 0.01 micron on the average. The particles thus obtained were mixed together by adding a dispersing agent and a bonding agent to obtain the metallic paste. The composition of this metallic paste was, on weight basis, 40% of gold, 1% of dispersing agent, 5% of bonding agent and 54% of solvent.

A conductive film was made by using the above-described metallic paste.

First, by using a 400-mesh screen, fine line-and-space patterns of 50-50 microns were formed on an aluminum substrate with the above-described metallic paste. The coating thickness of the metallic paste was about 12 microns. The fine patterns were dried by keeping them at 120°C for 15 minutes in the atmosphere. They were then sintered in a muffle furnace under conditions of a peak temperature of 850°C and a retention time of 10 minutes, thereby making the conductive film.

The thickness of the conductive film became 0.5 micron, and a resistance value of 90m Ω/□ (0.5 micron) was obtained. This film thickness of 0.5 micron is about one-third of the minimum film thickness of 1.5 micron that was obtainable in the manufacturing with a conventional metallic paste, thus enabling a still thinner film thickness. In point of the resistance value, too, it was possible to obtain a value which is not far different from a conventional value; therefore, there was no problem in putting them into practical use. In addition, the deviation in the resistance value from line to line was small, thus verifying the feature of a paste of highly dispersed particles.

When the surface of the metallic thin film thus obtained was observed by an SEM (scanning electron microscope), it was confirmed, as shown in Fig. 2, that a smooth surface free from pin holes was obtained. Further, in order to test the adhesiveness of the metallic thin film on the substrate, an ultrahigh-frequency treatment was performed at 28kHz and 100W for 60 minutes. But there was found no phenomenon of peeling off or the like.

### Second Embodiment

By using the same apparatus as in the first embodiment, gold metal was evaporated under a condition of helium pressure of 10 Torr. By using butyl acetate as the organic solvent, a gold metal paste in which gold metal particles are highly dispersed was prepared. By using this metal paste a conductive film was made. The particle size of the above-described gold metal particles was 0.1 micron. The composition of this metallic paste was, on weight basis, 60% of gold metal, 1% of dispersing agent, 5% of bonding agent and 34% of solvent.

A conductive film was made by using the above-described metallic paste.

First, by using a 400-mesh screen, fine line-and-space patterns of 50-50 microns were formed on an aluminum substrate with the above-described metallic paste. The coating thickness of the metallic paste was about 16 microns. The fine patterns were dried by keeping them at 120°C for 15 minutes in the atmosphere They were then sintered in a muffle furnace under conditions of a peak temperature of 850°C and a retention time of 10 minutes, thereby making the conductive film. The thickness of the conductive film produced became 1.0 micron, and a resistance value of 40m Ω/□ (1.0 micron) was obtained. As a result of this, it was shown that, like in the above-described first embodiment, the conductive film had characteristics which were superior to those of the conventional paste for thick films or the organometallic paste.

Upon observation by an SEM, the surface of the conductive film which was made in this embodiment was found smooth without pin holes. Also good results were obtained in a peeling test.

### Third Embodiment

By using the same apparatus as in the first embodiment, gold metal was evaporated under a condition of helium pressure of 0.1 Torr. By using citronellol as the organic solvent, a gold metal paste in which gold metal particles are highly dispersed was prepared. By using this metal paste a conductive film was made. The particle size of the above-described gold metal particles was 0.001 micron. The composition of this metallic paste was, on weight basis, 8% of gold metal and 92% of solvent.

A conductive film was made by using the above-described metallic paste.

By using a 400-mesh screen, a conductive film was formed on a glass substrate with the above-described metallic paste. The coating thickness of the metallic paste was about 1.2 microns. The film was dried by keeping it at 120°C for 15 minutes in the atmosphere. It was then sintered in a muffle furnace under conditions of a peak temperature of 800°C and a retention time of 10 minutes, thereby making the conductive film. The thickness of the conductive film produced became 0.01 micron, and a resistance value of 10 Ω/□ (0.01 micron) was obtained.

Upon observation by an SEM, the surface of the conductive film which was made in this embodiment was found smooth without pin holes.

### Fourth Embodiment

By using the same apparatus as in the first embodiment, a silver alloy containing, on weight basis, 25% palladium was evaporated under a condition of helium pressure of 0.5 Torr. By using α-terpineol as the organic solvent, an alloy metal paste in which silver-palladium alloy particles are highly dispersed was prepared. By using this metal paste a conductive film was made. The particle size of the above-described silver-palladium alloy particles was 0.02 micron. The composition of this metallic paste was, on weight basis, 50% of silver-palladium alloy, 0.5% of dispersing agent, 5% of bonding agent and 44.5% of solvent.

A conductive film was made by using the above-described metallic paste.

First, by using a 400-mesh screen, fine line-and-space patterns of 50-50 microns were formed on an aluminum substrate with the above-described metallic paste. The coating thickness of the metallic paste was about 8 microns. The fine patterns were dried by keeping them at 120°C for 15 minutes in the atmosphere. They were then sintered in a muffle furnace under conditions of a peak temperature of 900°C and a retention time of 10 minutes, thereby making the conductive film. The thickness of the conductive film produced became 0.4 micron, and a resistance value of Ω/□ (0.4 micron) was obtained. As a result of this, it was shown that, like in the above-described first embodiment, the conductive film had characteristics which were superior to those of the conventional paste for thick films or the organometallic paste.

Upon observation by an SEM, the surface of the conductive film which was made in this embodiment was found smooth without pin holes. Also good results were obtained in a peeling test.

### Fifth Embodiment

By using the same apparatus as in the first embodiment, ruthenium was evaporated under a condition of helium pressure of 0.5 Torr. By using α-terpineol as the organic solvent, a ruthenium paste in which ruthenium particles are highly dispersed was prepared. Further, under the same conditions, a silicon paste and a bismuth paste were prepared by using silicon and bismuth, respectively, instead of ruthenium. The particle diameters of ruthenium particles, silicon particles and bismuth particles were 0.01 micron, 0.005 micron and 0.005 micron, respectively. Then, a metallic paste was prepared by using them. The composition of the above-described metallic paste was, on weight basis, 35% of ruthenium, 5% of silicon, 2% of bismuth, 1% of dispersing agent, 5% of bonding agent and 52% of solvent.

A conductive film was made by using the above-described metallic paste.

First, by using a 400-mesh screen, fine line-and-space patterns of 50-50 micron were formed on an aluminum substrate with the above-described metallic paste. The coating thickness of the metallic paste was about 11 microns. The fine patterns were dried by keeping them at 120°C for 15 minutes in the atmosphere. They were then sintered in a muffle furnace under conditions of a peak temperature of 900°C and a retention time of 15 minutes, thereby making a conductive film. The thickness of the conductive film produced was 0.5 micron, and a resistance value of 240m Ω/□ (0.5 micron) was obtained.

Upon observation by an SEM, the surface of the conductive film which was made in this embodiment was found smooth without pinholes. Also good results were obtained in a peeling test.

## Claims

1. A method of making a metallic thin film from a metallic paste, comprising the steps of:
preparing the metallic paste by evaporating metal and condensing metal vapor thus obtained in an atmosphere of vapor of an organic solvent (14) to form ultrafine metallic particles (17) each of which has a particle size of about 0.001 µm to 0.1 µm in diameter, coating the metallic paste on a substrate; and then drying and sintering the coated metallic paste to obtain the metallic thin film of a thickness range between about 0.01 µm and 1 µm, **characterized in that** the metal paste is prepared, according to an apparatus provided with an evaporating chamber (1) for evaporating the metal, to which a gas passage (3) is connected for introducing a helium gas, and a collection chamber (2) provided with a cooling plate (12) therein, to which another passage (5) for introducing the vapor of organic solvent is connected in the neighborhood of a connecting portion of the collection chamber (2) to the evaporating chamber (1), both of the chambers (1) and (2) being in communication with each other, the metal paste preparation comprising the steps of first evacuating said evaporating chamber (1) and collection chamber (2) by means of a pump connected to the collection chamber (2), introducing the helium gas through the passage (3) into the evaporating chamber (1) while continuing the evacuation, then generating the metal vapor in the evaporating chamber (1) and transferring the metal vapor generated in the evaporating chamber (1) therefrom to the collection chamber (2) with the flow of the helium gas, the metal vapor (15) condensing in the flow of helium gas to form the ultrafine metallic particles (17) while introducing the organic solvent vapor (14) through the passage (5) into the collection chamber (2), mixing the ultrafine metallic particles (17) with the organic solvent vapor (14) in the collection chamber (2), and depositing the mixed ultrafine metallic, particles (17) and organic solvent vapor (14) on the cooling plate (12), each of the deposited metallic particles (17) being covered with a film of the organic solvent (16), whereby the ultrafine metallic particles (17) are uniformly and highly dispersed in the organic solvent (14, 16).

2. A method of making a metallic thin film according to claim 1, wherein said ultrafine metallic particles (17) are at least one of the group comprising silver, gold, nickel, indium, tin, zinc, titanium, copper, chromium, tantalum, tungsten, palladium, platinum, iron, cobalt, silicon, rhodium, iridium, ruthenium and osmium or an alloy of said metals.

3. A method of making a metallic thin film according to claim 1 or 2, wherein said organic solvent (14, 16) is a solvent containing one or more of alcohols having 5 carbon atoms or more such as terpineol, citronellol, geraniol, nerol and phenethyl alcohol, or a solvent containing one or more of organic esters such as ethyl acetate, ethyl oleate, butyl acetate and glyceride.

## Patentansprüche

1. Verfahren zum Herstellen eines Metall-Dünnfilms aus einer Metallpaste, welches die Schritte umfasst des:
Vorbereitens der Metallpaste durch Verdampfen von Metall und Kondensieren des Metalldampfes, der so erhalten wird, in eine Atmosphäre aus Dampf eines organischen Lösungsmittels (14), um ultrafeine Metall-Partikel (17) zu bilden, von welchen jeder eine Partikelgröße von ungefähr 0,001 µm bis 0,1 µm im Durchmesser aufweist,
Schichtens der Metallpaste auf ein Substrat; und dann Trocknen und Sintern der geschichteten Metallpaste, um den Metall-Dünnfilm in einem Dickenbereich zwischen ungefähr 0,01 µm und 1 µm zu erhalten,
**dadurch gekennzeichnet, dass**
die Metallpaste gemäß einer Vorrichtung vorbereitet wird, welche mit einer Verdampfungskammer (1) zum Verdampfen des Metalls, an welche ein Gasdurchgang (3) zum Einführen eines Heliumgases angeschlossen ist, und einer Sammelkammer (2) versehen ist, welche mit einer Kühlplatte (12) darin versehen ist, an welche ein weiterer Durchgang (5) zum Einführen des Dampfes des organischen Lösungsmittels in der Umgebung eines Verbindungsabschnitts der Sammelkammer (2) zu der Verdampfungskammer (1) angeschlossen ist, wobei beide der Kammern (1) und (2) in Kommunikation miteinander stehen, wobei die Metallpastenvorbereitung die Schritte umfasst des
zuerst Evakuierens der Verdampfungskammer (1) und Sammelkammer (2) mittels einer Pumpe, welche an die Sammelkammer (2) angeschlossen ist,
Einführens des Heliumgases durch den Durchgang (3) in die Verdampfungskammer (1), während die Evakuierung fortgesetzt wird,
dann Erzeugens des Metalldampfes in der Verdampfungskammer (1) und
Transferierens des Metalldampfes, welcher in der Verdampfungskammer (1) erzeugt wurde, von dort zu der Sammelkammer (2) mit dem Strom des Heliumgases, wobei der Metalldampf (15) in dem Strom des Heliumgases kondensiert, um die ultrafeinen Metallpartikel (17) zu bilden, während der organische Lösungsmitteldampf (14) durch den Durchgang (5) in die Sammelkammer (2) eingeführt wird,
Mischens der ultrafeinen Metallpartikel (17) mit dem organischen Lösungsmitteldampf (14) in der Sammelkammer (2), und
Ablagerns der gemischten ultrafeinen Metallpartikel (17) und des organischen Lösungsmitteldampfes (14) auf der Kühlplatte (12), wobei jeder der abgelagerten Metallpartikel (17) mit einem Film des organischen Lösungsmittels (16) bedeckt ist, wobei die ultrafeinen Metallpartikel (17) einheitlich und hoch dispergiert in dem organischen Lösungsmittel (14, 16) sind.

2. Verfahren zum Herstellen eines Metall-Dünnfilms gemäß Anspruch 1, wobei die ultrafeinen Metallpartikel (17) zumindest eines sind aus der Gruppe umfassend Silber, Gold, Nickel, Indium, Zinn, Zink, Titan, Kupfer, Chrom, Tantal, Wolfram, Palladium, Platin, Eisen, Kobalt, Silizium, Rhodium, Iridium, Ruthenium und Osmium oder eine Legierung der genannten Metalle sind.

3. Verfahren zum Herstellen eines Metall-Dünnfilms gemäß Anspruch 1 oder 2, wobei das organische Lösungsmittel (14, 16) ein Lösungsmittel ist, welches einen oder mehrere der Alkohole enthält, welche 5 Kohlenstoffatome oder mehr aufweisen, wie beispielsweise Terpineol, Citronellol, Geraniol, Nerol oder Phenethylalkohol, oder ein Lösungsmittel, welches eines oder mehrere der organischen Ester wie beispielsweise Ethylacetat, Ethyloleat, Butylacetat oder Glyzerid enthält.

## Revendications

1. Procédé de préparation d'un film mince métallique à partir d'une pâte métallique, comprenant les étapes consistant à :
préparer la pâte métallique en évaporant un métal et en condensant la vapeur de métal ainsi obtenue dans une atmosphère de vapeur d'un solvant organique (14) afin de former des particules métalliques ultrafines (17) ayant chacune une taille de particule d'environ 0,001 µm à 0,1 µm de diamètre,
déposer la pâte métallique sur un substrat ; et ensuite
sécher et fritter la pâte métallique déposée afin d'obtenir le film mince métallique avec une épaisseur dans la plage de 0,01 µm à 1 µm environ,
**caractérisé en ce que** la pâte métallique est préparée au moyen d'un appareil équipé d'une chambre d'évaporation (1) pour évaporer le métal, à laquelle est relié un passage de gaz (3) pour introduire de l'hélium gazeux, et d'une chambre de récupération (2) munie d'une plaque réfrigérante (12) contenue dedans, à laquelle est relié un autre passage (5) pour introduire la vapeur de solvant organique au voisinage d'une partie de raccordement de la chambre de récupération (2) à la chambre d'évaporation (1), les deux chambres (1) et (2) étant en communication l'une avec l'autre, la préparation de la pâte métallique comprenant les étapes consistant à :
premièrement, faire le vide dans ladite chambre d'évaporation (1) et dans ladite chambre de récupération (2) au moyen d'une pompe reliée à la chambre de récupération (2),
introduire l'hélium gazeux par le passage (3) dans la chambre d'évaporation (1) tout en continuant de faire le vide,
ensuite, générer la vapeur de métal dans la chambre d'évaporation (1) et
transférer la vapeur de métal générée dans la chambre d'évaporation (1) vers la chambre de récupération (2) avec le flux d'hélium gazeux, la vapeur de métal (15) se condensant dans le flux de l'hélium gazeux pour former les particules métalliques ultrafines (17), tout en introduisant la vapeur de solvant organique (14) par le passage (5) dans la chambre de récupération (2),
mélanger les particules métalliques ultrafines (17) avec la vapeur de solvant organique (14) dans la chambre de récupération (2), et
déposer les particules métalliques ultrafines mixtes (17) et la vapeur de solvant organique (14) sur la plaque réfrigérante (12), chacune des particules métalliques déposées (17) étant recouverte avec un film du solvant organique (16), les particules métalliques ultrafines (17) étant ainsi uniformément et hautement dispersées dans le solvant organique (14, 16).

2. Procédé de préparation d'un film mince métallique selon la revendication 1, dans lequel lesdites particules métalliques ultrafines (17) sont faites de l'un au moins des métaux du groupe comprenant l'argent, l'or, le nickel, l'indium, l'étain, le zinc, le titane, le cuivre, le chrome, le tantale, le tungstène, le palladium, le platine, le fer, le cobalt, le silicium, le rhodium, l'iridium, le ruthénium et l'osmium, ou d'un alliage desdits métaux.

3. Procédé de préparation d'un film mince métallique selon la revendication 1 ou la revendication 2, dans lequel ledit solvant organique (14, 16) est un solvant contenant un ou plusieurs alcools ayant 5 atomes de carbone ou plus tels que le terpinéol, le citronellol, le géraniol, le nérol et l'alcool phénéthylique, ou bien un solvant contenant un ou plusieurs esters organiques tels que l'acétate d'éthyle, l'oléate d'éthyle, l'acétate de butyle et un glycéride.
